(19) Europäisches Patentamt / European Patent Office / Office européen des brevets

(11) **EP 3 808 816 A1**

(12) **EUROPEAN PATENT APPLICATION**
published in accordance with Art. 153(4) EPC

(43) Date of publication:
**21.04.2021 Bulletin 2021/16**

(21) Application number: **19819725.3**

(22) Date of filing: **11.06.2019**

(51) Int Cl.:
**C08L 83/07** (2006.01)    **C08K 3/01** (2018.01)
**C08L 83/05** (2006.01)    **G02B 1/04** (2006.01)
**H01L 33/58** (2010.01)

(86) International application number:
**PCT/JP2019/023071**

(87) International publication number:
**WO 2019/240124 (19.12.2019 Gazette 2019/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.06.2018  JP 2018111813**

(71) Applicant: **Momentive Performance Materials Japan LLC**
**Tokyo 107-6119 (JP)**

(72) Inventor: **MOCHIZUKI, Kikuo**
**Tokyo 107-6119 (JP)**

(74) Representative: **Gille Hrabal**
**Partnerschaftsgesellschaft mbB**
**Patentanwälte**
**Brucknerstraße 20**
**40593 Düsseldorf (DE)**

(54) **POLYORGANOSILOXANE COMPOSITION FOR MOLDING, OPTICAL MEMBER, AND MOLDING METHOD**

(57)    To provide a polyorganosiloxane composition for molding with which good moldability in injection molding and so on is provided, release of a cured product from a metal mold is easily performed, and contamination of the metal mold is suppressed. A polyorganosiloxane composition for molding includes: (A) a straight-chain polyorganosiloxane having two or more alkenyl groups in one molecule, and having a viscosity (at 25°C) of 10,000 to 1,000,000 mPa·s; (B) 30 to 80 mass% of a resinoid polyorganosiloxane containing Q units, and having 1.5 or more alkenyl groups on average in one molecule, to a total of the components (A) and (B); (C) a polyorganohydrogensiloxane containing M units and Q units, having a molar ratio of alkoxy groups and Si-H of less than 0.15, and having a mass decrease rate when heated at 150°C for 30 minutes of 2.0% or less, wherein an amount of the (Si-H/alkenyl groups) is 1.0 to 3.0 mol; and (D) a catalytic amount of a hydrosilylation reaction catalyst.

EP 3 808 816 A1

**Description**

FIELD

The present invention relates to a polyorganosiloxane composition for molding, an optical member, and a molding method using the polyorganosiloxane composition for molding, and particularly relates to an addition reaction curing type polyorganosiloxane composition that forms a cured product excellent in metal mold release property and the like, an optical member formed by curing this polyorganosiloxane composition, and a molding method of the polyorganosiloxane composition.

BACKGROUND

Conventionally, polyorganosiloxane compositions curing into silicone rubber have been well known, and are widely used as a potting material, a coating material, a molding material for shaping, injection molding and so on, a covering material, and the like in an electric and electronic field, and optical and optoelectronics, sensor, architecture fields, by utilizing its excellent properties such as weather resistance, heat resistance, electrical insulation, hardness, mechanical strength, and elongation. Among them, a polyorganosiloxane composition which cures by an addition reaction increases in usage in each of the above-described fields because it quickly cures by appropriate heating and releases no corrosive material and the like during curing.

In the injection molding, in order to increase the productivity, it is required to remove the cured product from the metal mold as quick as possible and to perform next molding. For this reason, a polyorganosiloxane composition forming a cured product excellent in mold release property with respect to the metal mold is desired.

As the polyorganosiloxane composition for obtaining the cured product excellent in mold release property, a curing composition has been proposed which is made by mixing in advance an alkenyl group-containing polyorganosiloxane and a reinforcing filler, performing heat treatment or uniformly mixing them, then mixing a hydrogen atom-containing polyorganosiloxane and a platinum-based catalyst in the obtained compound base, and further mixing a polyorganosiloxane containing hydroxyl groups bonded to silicon atoms in a molecule as a component for improving the mold release property (refer to, for example, Patent Document 1).

Further, a silicone resin composition having good metal mold release property has been proposed which contains, as essential components, an organopolysiloxane having two or more alkenyl groups in one molecule, an organohydrogenpolysiloxane having two or more hydrogen atoms bonded to silicon atoms in one molecule, a platinum-based metal catalyst, and a release agent such as a fatty acid ester of an erythritol derivative (refer to, for example, Patent Document 2).

However, both of the compositions described in Patent Document 1 and Patent Document 2 are insufficient in mold release property of the cured product with respect to the metal mold. Further, when molding is repeated, a coating film of silicone is formed on the surface (molding surface) of the metal mold, resulting in that quality of a molded product (lens or the like) is reduced, which is a problem. Accordingly, it is required to wash the molding surface of the metal mold to remove the silicone coating film, but, it is difficult to wash the metal mold having a complicated shape, and thus a molding silicone composition which does not contaminate the metal mold is desired.

A composition has been proposed, as a silicone composition which is unlikely to contaminate a metal mold, which contains an organopolysiloxane having two or more alkenyl groups on average in a molecule, a resinous polymer having a monofunctional siloxane unit and a tetrafunctional siloxane unit at a predetermined molar ratio, an organohydrogenpolysiloxane containing two or more hydrogen atoms (Si-H groups), and a hydrosilylation reaction catalyst, in which a content of organopolysiloxane having the degree of polymerization of 10 or less and containing one or more Si-H groups, is 0.5 mass% or less (refer to, for example, Patent Document 3).

Further, as a component containing an alkenyl group, there has been proposed a polyorganosiloxane composition which contains a straight-chain polyorganosiloxane and a resinoid polyorganosiloxane having a tetrafunctional siloxane unit, in which the molar ratio of the alkoxy groups bonded to silicon atoms to the alkyl groups (the number of moles of alkoxy groups/the number of moles of substituted or unsubstituted alkyl groups) is suppressed to a certain value or less, to thereby improve the metal mold release property.

However, regarding these compositions, the mold release property of the cured products with respect to the metal mold is also insufficient, and thus it is not possible to sufficiently prevent the contamination of the metal mold.

RELEVANT REFERENCES

PATENT REFERENCE

Patent Reference 1: JP-A Hei 11-140319
Patent Reference 2: Japanese Patent No. 4697405
Patent Reference 3: JP-A 2009-185257

SUMMARY

PROBLEMS TO BE SOLVED BY THE INVENTION

The present invention has been made to solve these problems, and an object thereof is to provide a polyorganosiloxane composition for molding with which good moldability in injection molding and so on is provided, release of a cured product from a metal mold is easily performed, and contamination of the metal mold is suppressed.

MEANS FOR SOLVING THE PROBLEMS

A polyorganosiloxane composition for molding of the present invention includes:

(A) a straight-chain polyorganosiloxane having two or more alkenyl groups bonded to silicon atoms on average in one molecule, and having a viscosity at 25°C of 10,000 to 1,000,000 mPa·s;
(B) 30 to 80 mass% of a polyorganosiloxane having a resin structure to a total of the component (A) and the component (B), the polyorganosiloxane containing tetrafunctional siloxane units represented by a formula: $SiO_{4/2}$, and having 1.5 or more alkenyl groups bonded to silicon atoms on average in one molecule;
(C) a polyorganohydrogensiloxane having three or more hydrogen atoms bonded to silicon atoms on average in one molecule, and having monofunctional siloxane units represented by a formula: $R^4{}_3SiO_{1/2}$, where $R^4$s independently represent a methyl group or a hydrogen atom, and tetrafunctional siloxane units represented by a formula: $SiO_{4/2}$, the polyorganohydrogensiloxane having zero or more alkoxy groups bonded to silicon atoms, having a molar ratio of the alkoxy groups to the hydrogen atoms bonded to the silicon atoms (a number of moles of alkoxy groups/a number of moles of hydrogen atoms bonded to silicon atoms) of less than 0.15, and having a mass decrease rate when heated at 150°C for 30 minutes of 2.0% or less, wherein an amount of the hydrogen atoms bonded to the silicon atoms in the component (C) becomes 1.0 to 3.0 mol to a total 1 mol of the alkenyl groups in the component (A) and the alkenyl groups in the component (B); and
(D) a catalytic amount of a hydrosilylation reaction catalyst.

An optical member of the present invention is made by curing the above-described polyorganosiloxane composition for molding of the present invention.
A molding method of the present invention includes: performing molding by a method selected from injection molding, compression molding, transfer molding, potting, and dispensing, by using the above-described polyorganosiloxane composition for molding of the present invention.
Note that in the following description, an "alkenyl group bonded to a silicon atom" is sometimes referred to simply as an "alkenyl group". Further, a "hydrogen atom bonded to a silicon atom" is sometimes referred to as "Si-H". Furthermore, an "alkoxy group bonded to a silicon atom" is sometimes referred to simply as an "alkoxy group".
In the present description, a "viscosity" indicates a viscosity measured according to JIS K6249 by using a rotational viscometer at 25°C.

EFFECT OF THE INVENTION

According to the polyorganosiloxane composition for molding of the present invention, it is possible to obtain a cured product having good moldability in injection molding and so on, and having excellent metal mold release property and mechanical properties (strength, elongation, and the like). Further, the mold release property of the cured product is good and thus excellent non-contamination property with respect to the metal mold is provided, which brings about excellent productivity of molded products.

DETAILED DESCRIPTION

Hereinafter, embodiments of the present invention will be described.

[Polyorganosiloxane composition for molding]

A polyorganosiloxane composition for molding of an embodiment of the present invention includes:

(A) a straight-chain polyorganosiloxane having two or more alkenyl groups on average in one molecule, and having a viscosity at 25°C of 10,000 to 1,000,000 mPa·s;

(B) 30 to 80 mass% of a polyorganosiloxane having a resin structure to a total of the component (A) and the component (B), the polyorganosiloxane containing tetrafunctional siloxane units represented by a formula: $SiO_{4/2}$ and having 1.5 or more alkenyl groups on average in one molecule;

(C) a polyorganohydrogensiloxane having three or more Si-H on average in one molecule, and having monofunctional siloxane units represented by a formula: $R^1_3SiO_{1/2}$, where $R^1$s independently represent a methyl group or a hydrogen atom, and tetrafunctional siloxane units represented by a formula: $SiO_{4/2}$, the polyorganohydrogensiloxane having zero or more alkoxy groups, having a molar ratio of the alkoxy groups to the Si-H (a number of moles of alkoxy groups/a number of moles of Si-H) of less than 0.15, and having a mass decrease rate when heated at 150°C for 30 minutes of 2.0% or less, wherein an amount of Si-H in the component (C) is 1.0 to 3.0 mol to a total 1 mol of the alkenyl groups in the component (A) and the alkenyl groups in the component (B); and

(D) a catalytic amount of a hydrosilylation reaction catalyst.

Hereinafter, the respective components of (A) to (D) will be described.

<Component (A)>

The component (A) is a polyorganosiloxane having two or more alkenyl groups on average in one molecule, and having a viscosity at 25°C of 10,000 to 1,000,000 mPa·s (10 to 1,000 Pa·s). The molecular structure of the component (A) is a linear shape having a main chain basically composed of repeated diorganosiloxane units and both ends terminated with triorganosiloxy groups. The component (A) is a base polymer of the polyorganosiloxane composition for molding of the present invention, together with the later-described component (B).

As an alkenyl group bonded to a silicon atom in the component (A), there can be cited the ones having a number of carbon atoms of 2 to 8, more preferably 2 to 4, such as a vinyl group, an allyl group, a butenyl group, a pentenyl group, a hexenyl group, and a heptenyl group. The vinyl group is particularly preferable as the alkenyl group. The alkenyl group may be bonded to a silicon atom at either the end of a chain or the middle of the chain other than the end, or may be bonded to silicon atoms at both of the end and the middle of the chain.

As an organic group bonded to a silicon atom other than the alkenyl group in the component (A), there can be cited an unsubstituted or substituted monovalent hydrocarbon group. As the unsubstituted monovalent hydrocarbon group, there can be cited: alkyl groups having a number of carbon atoms of 1 to 10, such as a methyl group, an ethyl group, a propyl group, a butyl group, a pentyl group, a hexyl group, a cyclohexyl group, and a heptyl group; aryl groups having a number of carbon atoms of 6 to 14, such as a phenyl group, a tolyl group, a xylyl group, and a naphthyl group; and aralkyl groups having a number of carbon atoms of 7 to 14, such as a benzyl group and a phenethyl group. Further, as the substituted monovalent hydrocarbon group, there can be cited halogenated alkyl groups such as a chloromethyl group, a 3-chloropropyl group, and a 3,3,3-trifluoropropyl group. As the organic group other than the alkenyl group, the methyl group or the phenyl group is preferable, and the methyl group is particularly preferable.

The viscosity at 25°C of the component (A) is 10,000 to 1,000,000 mPa·s. The viscosity of the component (A) is preferably 10,000 to 700,000 mPa·s, more preferably 50,000 to 500,000 mPa·s, and particularly preferably 60,000 to 200,000 mPa·s. When the viscosity of the component (A) is 10,000 to 1,000,000 mPa·s, workability of the composition to be obtained is good, and besides, mechanical properties of a cured product to be obtained from this composition also become good.

As concrete examples of the component (A), there can be cited both ends trimethylsiloxy group-terminated dimethylsiloxane/methylvinylsiloxane copolymer, both ends dimethylvinylsiloxy group-terminated dimethylsiloxane/methylphenylsiloxane copolymer, both ends dimethylvinylsiloxy group-terminated dimethylpolysiloxane, both ends dimethylvinylsiloxy group-terminated dimethylsiloxane/methylvinylsiloxane copolymer, both ends dimethylvinylsiloxy group-terminated dimethylsiloxane/methylvinylsiloxane/methylphenylsiloxane copolymer, both ends trivinylsiloxy group-terminated dimethylpolysiloxane, both ends dimethylvinylsiloxy group-terminated dimethylsiloxane/diphenylsiloxane copolymer, and the like.

One kind of the polymers or copolymers can be used independently, or two or more kinds of them can be used in combination. In the case of using, among them, a straight-chain polyorganosiloxane in which all of organic groups other than the alkenyl groups bonded to silicon atoms are methyl groups, namely, both ends trimethylsiloxy group-terminated dimethylsiloxane/methylvinylsiloxane copolymer, both ends dimethylvinylsiloxy group-terminated dimethylpolysiloxane, or both ends dimethylvinylsiloxy group-terminated dimethylsiloxane/methylvinylsiloxane copolymer, a cured product excellent in mechanical properties such as tensile strength and elongation can be obtained.

\<Component (B)\>

The component (B) is a polyorganosiloxane having a resin structure (three-dimensional network structure) that contains a tetrafunctional siloxane unit represented by a formula: $SiO_{4/2}$ (hereinafter, referred to as Q unit), and has 1.5 or more alkenyl groups on average in one molecule. Hereinafter, "having a resin structure" will be also referred to as "resinoid".

By using, as the component (B), the resinoid polyorganosiloxane containing the Q units and having 1.5 or more alkenyl groups on average in one molecule, it is possible to obtain a composition having good mold release property with respect to a metal mold. When a resinoid polyorganosiloxane having less than 1.5 alkenyl groups on average, is used, the mold release property and the non-contamination property of the composition with respect to the metal mold deteriorate. The range of the number of alkenyl groups possessed by the component (B) is more preferably 2 or more on average in one molecule, and particularly preferably 2.3 or more on overage.

From a viewpoint of the metal mold release property and the non-contamination property, the resinoid polyorganosiloxane being the component (B) is preferably one having one or more substituted or unsubstituted alkyl groups bonded to silicon atoms in one molecule, and having zero or more alkoxy groups bonded to silicon atoms in one molecule, in which the molar ratio of the alkoxy groups to the substituted or unsubstituted alkyl groups (the number of moles of alkoxy groups/the number of moles of substituted or unsubstituted alkyl groups, hereinafter, referred to also as alkoxy groups/alkyl groups) is 0.030 or less. A more preferable value of the alkoxy groups/alkyl groups is 0.020 or less.

Note that the above-described resinoid polyorganosiloxane having zero or more alkoxy groups in one molecule also includes a polyorganosiloxane having zero alkoxy groups, and a value of the alkoxy groups/alkyl groups of zero.

Note that the value of the alkoxy groups/alkyl groups in the component (B) can be easily determined by measuring the contents (numbers of moles) of the alkoxy groups and alkyl groups by using a nuclear magnetic resonance spectroscopy (NMR) or the like.

As the resinoid polyorganosiloxane being the component (B), it is preferable to use a polyorganosiloxane containing monofunctional siloxane units represented by a formula: $R^1_3SiO_{1/2}$, bifunctional siloxane units represented by a formula: $R^1_2SiO_{2/2}$, tetrafunctional siloxane units represented by a formula: $SiO_{4/2}$ (Q units), and having 1.5 or more alkenyl groups on average in one molecule. By using such a polyorganosiloxane, it is possible to obtain a composition excellent in the metal mold release property and the non-contamination property.

In the above unit formulae, $R^1$s independently represent an alkenyl group or a substituted or unsubstituted alkyl group. On average, 1.5 of a plurality of $R^1$s existing in one molecule of the resinoid polyorganosiloxane are alkenyl groups. As the alkenyl group, there can be cited a vinyl group, an allyl group, a butenyl group, a pentenyl group, a hexenyl group, a heptenyl group, and the like. The vinyl group is preferable as the alkenyl group. As the unsubstituted alkyl group, there can be cited a methyl group, an ethyl group, a propyl group, a butyl group, a pentyl group, a hexyl group, a heptyl group, and the like. As the substituted alkyl group, there can be cited halogen-substituted alkyl groups with a hydrogen atom substituted by a halogen atom, such as a chloromethyl group, a 3-chloropropyl group, and a 3,3,3-trifluoropropyl group. As the substituted or unsubstituted alkyl group, the methyl group is preferable.

Further, as described above, the (B) resinoid polyorganosiloxane can include units represented by a formula: $(R^0O_{1/2})$, namely, alkoxy groups represented by $-OR^0$ bonded to silicon atoms. Here, $R^0$ is an unsubstituted alkyl group, for example, an alkyl group having a number of carbon atoms of 1 to 3. As the unsubstituted alkyl group, a methyl group or an ethyl group is preferable. Hereinafter, the $-OR^0$ group bonded to a silicon atom is also referred to simply as "$-OR^0$ group", unless otherwise noted.

Further, as the (B) resinoid polyorganosiloxane, there can be cited

a copolymer having siloxane units composed of monofunctional siloxane units represented by a formula: $R^2_3SiO_{1/2}$ ($R^2$ represents an unsubstituted alkyl group, and a plurality of $R^2$s may be different, this also applies to the following) (hereinafter, also referred to as $R^2_3SiO_{1/2}$ units), monofunctional siloxane units represented by a formula: $R^2_2R^3SiO_{1/2}$ ($R^3$ represents an alkenyl group, this also applies to the following) (hereinafter, also referred to as $R^2_2R^3SiO_{1/2}$ units), bifunctional siloxane units represented by a formula: $R^2_2SiO_{2/2}$ (hereinafter, also referred to as $R^2_2SiO_{2/2}$ units), and tetrafunctional siloxane units represented by a formula: $SiO_{4/2}$ (Q units),

a copolymer having siloxane units composed of the $R^2_3SiO_{1/2}$ units, the $R^2_2R^3SiO_{1/2}$ units, and the Q units,

a copolymer having siloxane units composed of the $R^2_2R^3SiO_{1/2}$ units, the $R^2_2SiO_{2/2}$ units, and the Q units, and so on. One kind of the copolymers can be used independently, or two or more kinds of them can be used in combination.

Among the above-described copolymers, the copolymer having the siloxane units composed of the $R^2_3SiO_{1/2}$ units, the $R^2_2R^3SiO_{1/2}$ units, and the Q units is preferable. From the viewpoint of the metal mold release property and the non-contamination property, a copolymer having as less $-OR^0$ groups as possible is more preferable, and a copolymer having no $-OR^0$ group is particularly preferable.

More concretely, a copolymer having the siloxane units composed of monofunctional siloxane units represented by a formula: $(CH_3)_2(CH_2=CH)SiO_{1/2}$ (hereinafter, expressed as $M^{vi}$ units), monofunctional siloxane units represented by a formula: $(CH_3)_3SiO_{1/2}$ (hereinafter, expressed as M units), and tetrafunctional siloxane units represented by a formula: $SiO_{4/2}$ (Q units), is preferable. Further, a copolymer composed only of such siloxane units and having no alkoxy groups, is particularly preferable.

Generally, the resinoid polyorganosiloxane can be obtained by adding water to chlorosilane and alkoxysilane to hydrolyze them. To obtain the (B) resinoid polyorganosiloxane to be compounded in the composition of the present invention, it is preferable to cause a hydrolysis reaction while adjusting the content ratio of the alkoxy groups (methoxy groups, ethoxy groups, and the like) to a certain content ratio or less.

A method of adjusting the content ratio of the alkoxy groups to the certain content ratio or less is not particularly limited, and examples of the method include controlling the reaction temperature, time, or the like of the hydrolysis, performing extraction and removal using a water-soluble solvent such as alcohol or acetone, and the like. The resinoid polyorganosiloxane having a low content ratio of the alkoxy groups can be obtained, for example, by performing the following steps (1) to (3) in sequence.

(1) A step of hydrolyzing at least three kinds of silicon compounds selected from formulas: $R^1_3SiW$, $R^1_2SiW_2$, $SiW_4$, with a mixed solution of acetone and water.
(2) A step of removing acid and acetone by water washing after the step (1).
(3) A step of adding alkali and heating after the step (2).

In the silicon compounds used as starting materials in the step (1), $R^1$s independently represent an alkenyl group or a substituted or unsubstituted alkyl group, and the same groups as described above can be exemplified. Besides, Ws independently represent a chlorine atom, an alkoxy group, or a hydroxyl group. Examples of the silicon compounds include tetraethoxysilane, chlorodimethylvinylsilane, chlorotrimethylsilane, dichlorodimethylsilane, and the like. Further, three or more kinds among those silicon compounds are selected to be used.

Note that as at least one kind of the three kinds of silicon compounds used as the starting materials, a silicon compound having one or more alkenyl groups as $R^1$s is used. Further, it is preferable to use, as at least one kind of silicon compound, a silicon compound having one or more chlorine atoms as Ws.

The mixing ratio between acetone and water is preferably in a range of acetone:water of 1:1 to 1:4 (mass ratio). The hydrolysis can be performed by a publicly-known method. Further, in the step (2), the water washing method is not particularly limited, and a publicly-known method can be used.

In the step (3), as the alkali to be added to the solution obtained in the step (2), there can be cited potassium hydroxide, cesium hydroxide, and the like. Further, such alkali is added by a publicly-known method and heating and dehydration are performed, and then neutralization is performed using a phosphoric acid or the like to obtain the resinoid polyorganosiloxane.

Further, in the synthesis of the resinoid polyorganosiloxane based on such a method, it was found out that various properties deteriorate if an alkali metal derived from an alkaline catalyst used in the step (3), or phosphorus derived from phosphoric acid used as a neutralizing agent remains in the composition.

In order to provide stable and good properties (metal mold release property, storage stability, and so on) to the composition, the (B) resinoid polyorganosiloxane obtained by the above-described method is preferably one in which phosphorus (P) and alkali metal remain as less as possible.

Concretely, a ratio of the total of the contents of phosphorus (P) and alkali metal in the (B) resinoid polyorganosiloxane to the component (B) is preferably 30 mass ppm or less. Further, the content ratio of phosphorus in the component (B) is preferably 25 mass ppm or less, and the content ratio of potassium is preferably 2 mass ppm or less.

Here, as the alkali metal, there can be cited sodium (Na), potassium (K), cesium (Cs), and so on.

The contents of P and Cs in the component (B) can be measured by an inductively coupled plasma atomic emission spectrometry (ICP-AES) method. With respect to Cs, it is also possible to use an inductively coupled plasma mass spectrometry (ICP-MS) method with higher sensitivity. The contents of K and Na can be measured by an atomic absorption spectrometry (AAS) method.

The content ratio of phosphorus in the component (B) is more preferably 15 mass ppm or less, and most preferably, phosphorus is not substantially contained (the content is less than 10 ppm). Note that when a substance is "not substantially contained", this means that a content thereof is equal to or less than a detection sensitivity. The limit of detection sensitivity of P is about 10 mass ppm in the above-described measuring method. Besides, the content ratio of potassium in the component (B) is more preferably 1 mass ppm or less, and most preferably, potassium is not substantially contained (the content is less than 0.4 ppm). In the above-described measuring methods, the limit of the detection sensitivity of Cs is about 0.1 mass ppb in the ICP-MS method, and the limit of the detection sensitivity of K and Na is about 0.4 mass ppm.

The total of the contents of phosphorus and alkali metal in the component (B) is more preferably 20 mass ppm or less, and most preferably, phosphorus and alkali metal are not substantially contained (the content is less than 10 ppm). Note that the limit of the detection sensitivity of the total amount of phosphorus and alkali metal is set to the limit of the detection sensitivity of phosphorus, namely, 10 ppm, since the limit of the detection sensitivity of alkali metal is very small when compared to the limit of the detection sensitivity of phosphorus.

In order to adjust the contents of phosphorus and alkali metal in the component (B) to fall within the above-described range, phosphorus and alkali metals such as sodium, potassium, and Cs are removed through a method such that the component (B) is subjected to water washing, treatment with an ion-exchange resin, or treatment with an adsorbent. Note that as the adsorbent, it is possible to use a solid basic adsorbent such as aluminum silicate powder, silica powder, or magnesium silicate powder.

A preferable mass average molecular weight Mw of the resinoid polyorganosiloxane being the component (B) is 1,500 to 10,000, and is more preferably in a range of 2,200 to 8,000. Note that Mw is a value when converted into polystyrene by gel permeation chromatography (hereinafter, described as GPC). When the Mw of the (B) resinoid polyorganosiloxane is less than 1,500, there is a case where sufficient mechanical strength cannot be stably obtained. When the Mw exceeds 10,000, there is a case where the viscosity of this composition increases to lose flowability and deteriorate an injection molding property.

The resinoid polyorganosiloxane being the component (B) becomes a polymer component of the composition of the present invention together with the straight-chain polyorganosiloxane being the component (A). The compounding ratio between the (B) resinoid polyorganosiloxane and the (A) straight-chain polyorganosiloxane is such a ratio that the component (B) is 30 to 80 mass% and the component (A) is 70 to 20 mass% to the total (100 mass%) of the component (A) and the component (B). When the compounding ratio of the component (B) is less than 30 mass%, sufficient hardness and mechanical strength cannot be obtained. When the compounding ratio of the component (B) is more than 80 mass%, the viscosity of the composition becomes high to deteriorate workability. The compounding ratio of the component (B) to the total of the (A) component and the component (B) is more preferably 35 to 70 mass%, and particularly preferably 37 to 65 mass%.

<Component (C)>

The component (C) is a resinoid polyorganohydrogensiloxane having three or more hydrogen atoms bonded to silicon atoms (Si-H) on average in one molecule, and having monofunctional siloxane units represented by a formula: $R^4_3SiO_{1/2}$ (in the formula, $R^4$s independently represent a methyl group or a hydrogen atom), and tetrafunctional siloxane units represented by a formula: $SiO_{4/2}$ (Q units). The component (C) acts as a crosslinking agent by reaction of its Si-H with the alkenyl groups in the component (A) and the component (B).

The resinoid polyorganohydrogensiloxane being the component (C) has zero or more alkoxy groups bonded to silicon atoms in one molecule, and has a molar ratio of the alkoxy groups to the hydrogen atoms bonded to the silicon atoms (Si-H) described above (the number of moles of alkoxy groups/the number of moles of Si-H, which is also referred to as alkoxy groups/Si-H, hereinafter) of less than 0.15.

Here, the resinoid polyorganohydrogensiloxane having zero or more alkoxy groups bonded to silicon atoms also includes one having zero alkoxy groups in one molecule and a value of the alkoxy groups/Si-H of zero.

As described above, the metal mold release property and the non-contamination property of the composition can be improved by reducing the content of alkoxy groups in the component (B), but, the effect brought by reducing the alkoxy groups in the component (C) is larger than that. Although the content of the resinoid polyorganohydrogensiloxane being the component (C) is smaller than that of the resinoid polyorganosiloxane being the component (B), the resinoid polyorganohydrogensiloxane acts greatly to increase adhesiveness of the composition with respect to the metal mold, so that by reducing the content of the alkoxy groups in the component (C) to make the alkoxy groups/Si-H to be less than 0.15, it is possible to more effectively increase the mold release property and the non-contamination property of the entire composition with respect to the metal mold.

From the viewpoint of the metal mold release property and the non-contamination property, the number of alkoxy groups ($-OR^0$ groups) possessed by the resinoid polyorganohydrogensiloxane being the component (C) is as small as possible, and a copolymer having no $-OR^0$ group is particularly preferable.

When a resinoid polyorganohydrogensiloxane having alkoxy groups/Si-H of 0.15 or more is used as the component (C), a composition to be obtained deteriorates in metal mold release property to become more likely to contaminate the metal mold. The molar ratio (alkoxy groups/Si-H) of the (C) resinoid polyorganohydrogensiloxane is more preferably less than 0.1, and particularly preferably 0.08 or less. The value of the alkoxy groups/Si-H is most preferably zero. The alkoxy groups/Si-H of the (C) resinoid polyorganohydrogensiloxane may be, for example, 0.005 or more and less than 0.1, and it may also be 0.03 or more and 0.08 or less. As the alkoxy group, concretely, there can be cited an alkoxy group having a number of carbon atoms of 1 to 3.

Note that the contents (number of moles) of the alkoxy groups and Si-H in the resinoid polyorganohydrogensiloxane can be easily determined by using a nuclear magnetic resonance spectroscopy (NMR) or the like.

Although a method of obtaining the resinoid polyorganohydrogensiloxane being the component (C) is not particularly limited, for example, chlorosilane and tetraalkoxysilane and/or polysilicate (for example, ethyl polysilicate) are subjected to cohydrolysis and condensation in an organic solvent such as xylene. It is also possible to employ a method in which 1,1,3,3-tetramethyldisiloxane, in place of chlorosilane, as the starting material, is charged together with hydrochloric acid, and disiloxane is decomposed under acidic conditions. Further, in order to obtain the (C) resinoid polyorganohydrogensiloxane having the alkoxy groups/Si-H groups of less than 0.15 to be used in the present invention, it is preferable to employ a method in which a water-soluble solvent such as alcohol is used to extract and remove the alkoxy groups.

Further, the component (C) is preferably a polyorganohydrogensiloxane having the average degree of polymerization of 10 or more and the content of Si-H of 5.0 mmol/g or more and 11.0 mmol/g or less. The average degree of polymerization corresponds to the number of silicon atoms in one molecule, and is also the number of siloxane units existing in one molecule. The average degree of polymerization of the component (C) is preferably 10 to 25, and more preferably 10 to 20.

Further, the (C) resinoid polyorganohydrogensiloxane of the present invention is one containing no low-molecular weight component, and having a mass decrease rate when heated at 150°C for 30 minutes of 2.0% or less. The mass decrease rate is more preferably 0.5% or less.

Note that the mass decrease rate is determined as a mass decrease rate of mass (Wa) after performing heating (at 150°C for 30 minutes) from mass (Wb) before performing heating, which is expressed by (Wb-Wa) / Wb × 100 (each of Wb and Wa is mass measured at 25°C), for example. Note that the heating can be performed in a manner that about 2 g of a sample is let stand for 30 minutes in a dryer set to 150°C, for example.

As the method of obtaining the polyorganohydrogensiloxane having the mass decrease rate of 2.0% or less, there can be cited, for example, a method of heating the polyorganohydrogensiloxane obtained in the aforementioned method to 130°C or more under a reduced pressure condition, a method of performing thin-film distillation, a method of performing molecular distillation, and the like. The thin-film distillation is a method of distilling a raw material in a thin film state by a wiper or centrifugal force under reduced pressure. In the thin-film distillation method, an increase in the boiling point due to liquid depth is suppressed and therefore distillation under a condition of a lower boiling point is possible. Besides, the molecular distillation is a method of performing distillation with a condensation plane (condenser) provided near an evaporation plane in addition to the above, and therefore distillation at a higher vacuum becomes possible.

As the resinoid polyorganohydrogensiloxane being the component (C), there can be cited a copolymer having siloxane units composed of $R^5{}_3SiO_{1/2}$ units, $R^5{}_2HSiO_{1/2}$ units, and $SiO_{4/2}$ units (Q units), a copolymer having siloxane units composed of $R^5{}_3SiO_{1/2}$ units, $R^3{}_2HSiO_{1/2}$ units, $R^5{}_2SiO_{2/2}$ units, and $SiO_{4/2}$ units (Q units), a copolymer having siloxane units composed of $R^5{}_3SiO_{1/2}$ units, $R^5{}_2HSiO_{1/2}$ units, $R^5{}_2SiO_{2/2}$ units, $R^5HSiO_{2/2}$ units, and $SiO_{4/2}$ units (Q units), a copolymer having siloxane units composed of $R^5{}_2HSiO_{1/2}$ units, and $SiO_{4/2}$ units (Q units), and the like. In the respective units, $R^5$ is a methyl group. Note that as long as the effect of the present invention is not impaired, the above-described respective copolymers may also include units, in the above-described respective units, in which $R^5$ is an alkyl group other than the methyl group, such as an ethyl group or a propyl group, for example.

More concretely, the (C) resinoid polyorganohydrogensiloxane is preferably a copolymer having siloxane units composed of monofunctional siloxane units represented by a formula: $(CH_3)_2HSiO_{1/2}$ (hereinafter, referred to as $M^H$ units), monofunctional siloxane units represented by a formula: $(CH_3)_3SiO_{1/2}$ (hereinafter, referred to as M units), and tetrafunctional siloxane units represented by a formula: $SiO_{4/2}$ (Q units), or a copolymer having siloxane units composed of the $M^H$ units and the Q units.

The compounding amount of the polyorganohydrogensiloxane being the component (C) is an effective amount for curing the component (A) and the component (B). Concretely, the compounding amount is set so that an amount of Si-H in the component (C) is 1.0 to 3.0 mol to a total 1 mol of the alkenyl groups in the component (A) and the alkenyl groups in the component (B). Specifically, the compounding amount is set so that the molar ratio of Si-H in the component (C) to the total alkenyl groups of the component (A) and the component (B) (the number of moles of Si-H/the number of moles of alkenyl groups; hereinafter, referred to as "Si-H/alkenyl groups") becomes 1.0 to 3.0. A preferable range of the Si-H/alkenyl groups is a range of 1.5 to 2.5. When the Si-H/alkenyl groups is less than 1.0, there is a possibility that the curing reaction does not proceed, and thus it becomes difficult to obtain a cured product. Further, when the Si-H/alkenyl groups exceeds 3.0, a large amount of unreacted Si-H remain in a cured product, thereby possibly changing the physical properties of the cured product over time.

<Component (D)>

The hydrosilylation reaction catalyst being the component (D) is a catalyst that promotes an addition reaction (hydrosilylation reaction) between the alkenyl groups in the component (A) and the component (B) and Si-H in the component (C). The hydrosilylation reaction catalyst is not particularly limited as long as it promotes the hydrosilylation reaction. A platinum-based metal compound is preferable, and a metallic catalyst such as palladium, rhodium, cobalt, nickel, ruthenium, or iron can also be used.

As the platinum-based metal compound, for example, a chloroplatinic acid, an alcohol solution of the chloroplatinic acid, a platinum complex having olefines, a vinyl group-containing siloxane, or an acetylene compound as a ligand or the like can be used.

The content of the (D) hydrosilylation reaction catalyst in the polyorganosiloxane composition for molding of the present invention is an amount (catalytic amount) capable of promoting the aforementioned hydrosilylation reaction. When the (D) hydrosilylation reaction catalyst is the platinum-based metal compound, the compounding amount thereof is the catalytic amount, and is concretely such an amount that its content ratio to the whole composition is 0.5 to 10 mass ppm when converted into a platinum element. It is more preferably 1 to 5 mass ppm, and still more preferably 1 to 3 mass ppm. When the compounding amount of the platinum-based metal compound is less than 0.5 mass ppm, the curability significantly decreases, whereas when it is more than 10 mass ppm, the transparency of the cured product decreases. When the compounding amount of the platinum-based metal compound is in a range of 0.5 to 10 mass ppm, a cured product having good physical properties can be obtained and economical advantage is also provided.

The polyorganosiloxane composition for molding of the present invention is prepared by uniformly mixing the above-described respective components. From a viewpoint of the metal mold release property and the non-contamination property, the polyorganosiloxane composition for molding of the present invention is preferably one in which the total of the contents of phosphorus and alkali metal is 20 mass ppm or less of the entire composition.

When the total content of phosphorus and alkali metal exceeds 20 mass ppm of the entire composition, the metal mold release property and the non-contamination property of the cured product are likely to be decreased. The viscosity of the compositions is also likely to be increased, which lowers the storage stability. When the total content of phosphorus and alkali metal is 20 mass ppm or less of the entire composition, it is possible to obtain a cured product excellent in the metal mold release property and the non-contamination property, and the storage stability of the composition is also good.

The total of the contents of phosphorus and alkali metal in the composition of the present invention is preferably 15 mass ppm or less, and most preferably, they are not substantially contained (the content is less than 10 ppm).

For measuring the contents of phosphorus and alkali metal in the composition, it is possible to employ a method similar to that of the measurement of the contents of phosphorus and alkali metal in the component (B). Specifically, the contents of P and Cs can be measured by the ICP-AES method, the content of Cs can be measured by the ICP-MS method with higher sensitivity, and the contents of K and Na can be measured by the AAS method.

In order to adjust the contents of phosphorus and alkali metal in the composition to fall within the above-described range, there is a method in which the component (B) is subjected to water washing, treatment with an ion-exchange resin, treatment with an adsorbent, or the like to remove phosphorus and alkali metal in the component (B), as described above. Other than the above, regarding the component (A) as well, water washing, treatment with an ion-exchange resin, treatment with an adsorbent, or the like is performed to remove phosphorus and alkali metal, or preparation is performed by using a thermally decomposable catalyst containing no alkali metal (for example, tetramethylammonium silanolate), to thereby adjust the total content of phosphorus and alkali metal as the entire composition to 20 mass ppm or less.

In order to adjust the curability, a reaction inhibitor can be added to the polyorganosiloxane composition for molding of the present invention. As the inhibitor for the curing reaction, there can be cited acetylene alcohols such as 3-methyl-1-butyne-3-ol, 2-phenyl-3-butyne-2-ol, and 1-ethynylcyclohexanol, and a maleic acid derivative such as maleic acid diallyl.

Further, the polyorganosiloxane composition for molding can also be stored while divided in two liquids to prevent curing from proceeding, and the two liquids can be mixed together in use for curing. For the two-liquid-mixing type, it is necessary to avoid storage of the polyorganohydrogensiloxane being the component (C) and the hydrosilylation reaction catalyst being the component (D) in the same wrapper in terms of the risk of a dehydrogenation reaction.

The viscosity of the polyorganosiloxane composition for molding of the present invention obtained as above is preferably in a range of 10,000 to 1,000,000 mPa·s. A more preferable range is 20,000 to 500,000 mPa·s, and a particularly preferable range is 50,000 to 300,000 mPa·s. When the viscosity is less than 10,000 mPa·s, molding failure such as liquid dripping or mixture of air during molding is likely to occur, whereas when the viscosity is more than 1,000,000 mPa·s, flowability deteriorates, and it is sometimes difficult to perform injection. In particular, a polyorganosiloxane for an injection molding containing no inorganic filler is difficult to increase viscosity, and therefore the viscosity of the component (A), the molecular weight of the component (B), the average degree of polymerization of the component (C), and the like are important.

The polyorganosiloxane composition for molding of the present invention preferably contains no inorganic filler. Even if the polyorganosiloxane composition for molding is made into a composition containing no inorganic filler, a cured product having sufficient rubber hardness and good mechanical properties (strength, elongation, and the like) can be obtained. Further, in the case of using the polyorganosiloxane composition for molding containing no inorganic filler, a cured product with high transmittance of light (for example, visible light) can be obtained.

The polyorganosiloxane composition for molding of the present invention cures by being heated according to need. Although the curing condition is not particularly limited, the composition cures by holding it normally at a temperature of 40 to 200°C, and preferably 60 to 170°C for about 0.5 minutes to 10 hours and preferably for about 1 minute to 6 hours.

[Molding method]

By molding and curing the polyorganosiloxane composition for molding of the present invention, a molded product can be obtained. The molding can be performed by a method selected from injection molding, compression molding, transfer molding, potting, and dispensing, and the injection molding is particularly preferable. The molded product being its cured product is excellent in property of releasing from the metal mold and non-contamination property with respect to the metal mold.

Further, the molded product has sufficient rubber hardness, good mechanical properties (strength, elongation), and good weather resistance. Further, a change in color, for example, yellowing is unlikely to occur over time. Besides, in the case of using the polyorganosiloxane composition for molding containing no inorganic filler, the molded product having a thickness of 6 mm has a high light transmittance so that a transmittance of light with a wavelength of 400 nm is 85% or more.

[Optical member]

The cured product made by molding and curing the polyorganosiloxane composition for molding of the present invention has excellent metal mold release property and non-contamination property, it has good mechanical properties and weather resistance, it is unlikely to change in color, for example, yellowing is unlikely to occur, and it has high light transmittance of visible light or the like, and therefore it can be used as an optical member. The cured product made by molding and curing the polyorganosiloxane composition for molding of the present invention is suitable for optical members such as a sealing material of a light-emitting element in a light emitting device such as an LED device, and a material of a functional lens.

As the optical member, the cured product can be suitably used as a lens and cover of various kinds of indoor or outdoor light sources and automobile light source. As the light source, there can be cited indoor or outdoor lighting, a reading light and accent lighting of public transport, an LED street light, and the like.

As the optical members, more concretely, there can be exemplified a primary or secondary LED lens, a thick optical lens, an LED reflector, an automobile LED matrix lighting lens, an augmented reality optical member, an LED chip silicone optical head, a work light lens and reflector, an illumination optical member for smartphone or tablet, an LED display for computer or television, a light guide, and the like.

EXAMPLES

Hereinafter, the present invention will be concretely described while citing examples, but, the present invention is not limited to the examples.

In the following description, an M unit, an $M^{vi}$ unit, an $M^H$ unit, and a Q unit represent siloxane units represented by the following formulae respectively, and an OE unit represents an organic unit represented by the following formula.

M unit ............ $(CH_3)_3SiO_{1/2}$
$M^{vi}$ unit ............ $(CH_3)_2(CH_2=CH)SiO_{1/2}$
$M^H$ unit ............ $(CH_3)_2HSiO_{1/2}$
Q unit ............ $SiO_{4/2}$
OE unit ............ $CH_3CH_2O_{1/2}$

The viscosity to be described hereinbelow is a viscosity measured according to JIS K6249 by using a rotational viscometer at 25°C. Further, the mass average molecular weight (Mw) is a value obtained by measurement using a gel permeation chromatography (GPC) apparatus (manufactured by Shimadzu Corporation, apparatus name; Prominence GPC system, column; Shim-pack GPC-80M) using toluene as a solvent, and converted into polystyrene. The nonvolatile content (mass%) is a value obtained by measurement under heating conditions of 150°C × 1 hour. Besides, the content of P was measured by the ICP-AES method, the content of Cs was measured by the ICP-MS method, and the contents of Na and K were measured by the AAS method.

[Synthesis example 1 (synthesis of straight-chain polydimethylsiloxane containing vinyl groups at both ends A1)]

Tetramethylammonium silanolate was used as a catalyst, and a straight-chain dimethylpolysiloxane A1 in which both ends of a chain were terminated with dimethylvinylsiloxy groups was synthesized through a publicly-known method.

A viscosity of the obtained straight-chain polydimethylsiloxane A1 was 80 Pa·s, and a content of the vinyl groups was 0.03 mmol/g (average number of vinyl groups in one molecule; two). Further, the contents of P, Cs, K, and Na in the polydimethylsiloxane A1 were measured, but, none of them was detected.

[Synthesis example 2 (synthesis of vinyl group-containing resinoid polysiloxane B1)]

970 g of tetraethoxysilane, 70 of chlorodimethylvinylsilane, 335 g of chlorotrimethylsilane, and 400 g of xylene were put into and stirred in a flask, and 900 g of a mixed solution composed of 600 g of water and 300 g of acetone was dropped thereinto. Stirring was performed at 70 to 80°C for 1 hour and hydrolysis was performed, and then liquid separation was performed to obtain a xylene solution. Subsequently, 500 g of water was added to the obtained xylene solution, and water washing and liquid separation were performed to extract acetone in the xylene solution into the water. Then, the operation of water washing and liquid separation was repeated until the water used for the washing exhibited neutrality.

Subsequently, 200 g of xylene and 0.18 g of potassium hydroxide were added to the obtained xylene solution, and stirring was performed while performing heating. After heating was performed up to 140°C, reflux was performed at 140°C for 3 hours. After cooling, neutralization was performed using a phosphoric acid to perform adjustment so that the nonvolatile content was 50 mass%, thereby obtaining a xylene solution of vinyl group-containing resinoid polysiloxane B0.

Note that it is found from the charged amounts of the starting materials that the obtained vinyl group-containing resinoid polysiloxane B0 has the $M^{vi}$ units, the M units, and the Q units, and the molar ratio among the units is $M^{vi}$ unit:M unit:Q unit = 0.07:0.37:0.56. Further, the content of vinyl groups was 1mmol/g (average number of vinyl groups in one molecule; 2.8), and the Mw of the vinyl group-containing resinoid polysiloxane B0 obtained by GPC was 2840.

Next, the xylene solution of the vinyl group-containing resinoid polysiloxane B0 obtained in the above was subjected to water washing of two times. Specifically, water was added to the xylene solution of the vinyl group-containing resinoid polysiloxane B0 and liquid separation was performed, and then heating was performed to 140°C to remove remaining water. After that, water was further added and liquid separation was performed, and then heating was performed to 140°C to remove remaining water. Subsequently, adjustment was performed so that the nonvolatile content became 50 mass%, thereby obtaining a xylene solution of vinyl group-containing resinoid polysiloxane B1.

In the obtained resinoid polysiloxane B1, the content of P was less than 10 mass ppm, namely, P was not detected, the content of K was 0.6 mass ppm, and Na and Cs were not detected.

[Synthesis example 3 (synthesis of vinyl group-containing resinoid polysiloxane B2)]

Water was added to the xylene solution of the vinyl group-containing resinoid polysiloxane B0 obtained in the synthesis example 2, liquid separation was performed, and then heating was performed to 140°C to remove remaining water. Subsequently, adjustment was performed so that the nonvolatile content became 50 mass%, thereby obtaining a xylene solution of vinyl group-containing resinoid polysiloxane B2.

In the obtained resinoid polysiloxane B2, the content of P was 17 mass ppm, the content of K was 1.2 mass ppm, and Na and Cs were not detected.

[Synthesis example 4 (synthesis of vinyl group-containing resinoid polysiloxane B3)]

The xylene solution of the vinyl group-containing resinoid polysiloxane B0 obtained in the synthesis example 2 was used as it was without being subjected to water washing, and it was set to a vinyl group-containing resinoid polysiloxane B3.

In the obtained resinoid polysiloxane B3, the content of P was 40 mass ppm, the content of K was 7 mass ppm, and Na and Cs were not detected.

[Synthesis example 5 (synthesis of resinoid polymethylhydrogensiloxane C1)]

425 g of 10% (mass%, the same applies to the description hereinbelow) hydrochloric acid and 1005 g of 1,1,3,3-tetramethyldisiloxane were charged in a reaction container equipped with a stirrer, a dropping device, a heating and cooling device, and a pressure reducing device. Subsequently, stirring was performed while dropping a mixture of 930 g of silicate 40 (ethyl polysilicate, product name of TAMA CHEMICALS CO., LTD.) and 375 g of ethanol at room temperature, and after that, 1200 g of xylene was added and stirring was performed. After that, an obtained organic layer was washed with water until the washing water exhibited neutrality, and further, methanol was used to extract a by-product. Next, after removing water and alcohol, xylene was distilled off at 150°C/667 Pa (5 mmHg), and heating and stirring under reduced pressure were continued while further introducing nitrogen gas, to thereby obtain a liquid polymethylhydrogensiloxane C1.

The mass decrease rate of the obtained polymethylhydrogensiloxane C1 when heated at 150°C for 30 minutes was 1.8%. Further, in the obtained polymethylhydrogensiloxane C1, a ratio between units obtained by the measurement of $^{29}$Si-NMR was $M^H$:Q = 1.7:1, and the Mw obtained by GPC was 1239. Further, the content ratio of Si-H was 9.4 mmol/g.

Further, regarding the polymethylhydrogensiloxane C1, a ratio between the number of hydrogen atoms derived from $CH_2$ groups in ethoxy groups and the number of hydrogen atoms bonded to silicon atoms (the number of hydrogen atoms derived from $CH_2$ groups/the number of hydrogen atoms derived from Si-H groups) was obtained by $^1$H-NMR. As a result of this, it was found out that the molar ratio of the alkoxy groups (ethoxy groups) to the hydrogen atoms bonded to the silicon atoms (Si-H) (hereinafter, referred to as OE/Si-H) was 0.13.

[Synthesis example 6 (synthesis of resinoid polymethylhydrogensiloxane C2)]

793 g of a 10% hydrochloric acid and 1219 g of 1,1,3,3-tetramethyldisiloxane were charged in a reaction container equipped with a stirrer, a dropping device, a heating and cooling device, and a pressure reducing device. Subsequently, stirring was performed while dropping a mixture of 1082 g of tetraethoxysilane, 484 g of silicate 40 (ethyl polysilicate, product name of TAMA CHEMICALS CO., LTD.), and 715 g of ethanol at room temperature, and after that, 1500 g of xylene was added and stirring was performed. After that, an obtained organic layer was washed with water until the washing water exhibited neutrality, and further, methanol was used to extract a by-product. Next, after removing water and alcohol, xylene was distilled off at 150°C/667 Pa (5 mmHg), heating and stirring under reduced pressure were continued while further introducing nitrogen gas, and thin-film distillation was further conducted. Specifically, a reaction solution after performing the heating and stirring was distilled at 150°C under the reduced pressure of 400 Pa (3 mmHg) using a thin-film distillation apparatus (manufactured by Kobelco Eco-Solutions Co., Ltd., apparatus name: TYPE 2-03 WIPRENE), and subjected to removal of a low-molecular weight substance having a low boiling point, to thereby obtain a liquid polymethylhydrogensiloxane C2.

The mass decrease rate of the obtained polymethylhydrogensiloxane C2 when heated at 150°C for 30 minutes was 0.1%. Further, in the obtained polymethylhydrogensiloxane C2, a ratio between units obtained by the measurement of $^{29}$Si-NMR was $M^H$:Q = 1.6:1, and the Mw obtained by GPC was 1138. Further, the content ratio of Si-H was 9.2 mmol/g.

Further, regarding the polymethylhydrogensiloxane C2, the molar ratio of the ethoxy groups to the hydrogen atoms obtained by $^1$H-NMR (Si-H) (OE/Si-H) was 0.08.

[Synthesis example 7 (synthesis of resinoid polymethylhydrogensiloxane C3)]

500 g of toluene, 830 g of tetraethoxysilane, and 760 g of dimethylchlorosilane were uniformly dissolved. This was dropped into excessive water put in a reaction container equipped with a stirrer, a dropping device, a heating and cooling device, and a pressure reducing device while being stirred, and cohydrolysis and condensation were performed at room temperature while heat of solution of a by-produced hydrochloric acid was being removed by cooling. Subsequently, an obtained organic layer was washed with water until the washing water exhibited neutrality, and then dehydrated, and toluene and a by-produced tetramethyldisiloxane were distilled off at 100°C/667 Pa (5 mmHg) to obtain a liquid polymethylhydrogensiloxane C3.

The mass decrease rate of the obtained polymethylhydrogensiloxane C3 when heated at 150°C for 30 minutes was 40%. Further, in the obtained polymethylhydrogensiloxane C3, a ratio between units obtained by the measurement of $^{29}$Si-NMR was $M^H$:Q = 2:1, and the Mw obtained by GPC was 775. Further, the content ratio of Si-H was 10.2 mmol/g.

Further, regarding the polymethylhydrogensiloxane C3, the molar ratio of the ethoxy groups to the hydrogen atoms (Si-H) obtained by $^1$H-NMR (OE/Si-H) was 0.03.

[Synthesis example 8 (synthesis of resinoid polymethylhydrogensiloxane C4)]

The polymethylhydrogensiloxane C3 obtained in the synthesis example 7 was further heated at 150°C/667 Pa (5 mmHg), to thereby remove a low-molecular weight substance having a low boiling point.

The mass decrease rate of thus obtained polymethylhydrogensiloxane C4 when heated at 150°C for 30 minutes was 12%. Further, in the obtained polymethylhydrogensiloxane C4, the content ratio of Si-H was 10.0 mmol/g.

Further, regarding the polymethylhydrogensiloxane C4, the molar ratio of the ethoxy groups to the hydrogen atoms (Si-H) obtained by $^1$H-NMR (OE/Si-H) was 0.03.

[Synthesis example 9 (synthesis of resinoid polymethylhydrogensiloxane C5)]

The synthesis was performed in a similar manner to the synthesis example 5 except that the extraction of by-product using methanol was not conducted. Specifically, 425 g of a 10% hydrochloric acid and 1005 g of 1,1,3,3-tetramethyldisiloxane were charged in a reaction container, stirring was performed while dropping a mixture of 930 g of silicate 40 and 375 g of ethanol at room temperature, and after that, 1200 g of xylene was added and stirring was performed. After that, an obtained organic layer was washed with water until the washing water exhibited neutrality, the water was then removed, and after that, xylene was distilled off at 150°C/667 Pa (5 mmHg), and heating and stirring under reduced pressure were continued while further introducing nitrogen gas. Subsequently, thin-film distillation was performed under a condition of 150°C/400 Pa (3 mmHg) to remove a low-molecular weight substance, thereby obtaining a liquid polymethylhydrogensiloxane C5.

The mass decrease rate of the obtained polymethylhydrogensiloxane C5 when heated at 150°C for 30 minutes was 0.2%. Further, in the obtained polymethylhydrogensiloxane C5, a ratio between units obtained by the measurement of $^{29}$Si-NMR was $M^H$:Q = 1.9: 1, the Mw obtained by GPC was 1264, and the content ratio of Si-H was 9.4 mmol/g.

Further, regarding the polymethylhydrogensiloxane C5, the molar ratio of the ethoxy groups to the hydrogen atoms (Si-H) obtained by $^1$H-NMR (OE/ Si-H) was 0.22.

[Example 1]

60 parts by mass (hereinafter, referred to simply as parts) of the straight-chain polydimethylsiloxane containing vinyl groups at both ends A1 (the viscosity of 80 Pa·s) obtained in the synthesis example 1, and 80 parts of the xylene solution (50 mass%) of the vinyl group-containing resinoid polysiloxane B1 obtained in the synthesis example 2 were mixed together (the mass ratio of mixture of (A1):(B1) = 60:40 by nonvolatile content), and heated to 150°C under a reduced pressure condition, to thereby remove xylene.

100 parts of thus obtained vinyl group-containing polymer mixture (1), 8.9 parts of the resinoid polymethylhydrogensiloxane C1 (the molar ratio of Si-H in the component (C1) to the vinyl groups in the vinyl group-containing polymer mixture (1) (Si-H/Vi) = 2.0) obtained in the synthesis example 5, and such an amount of the (D) platinum complex solution having a tetramethyltetravinylcyclotetrasiloxane as a ligand that it was 3 ppm of the whole composition as a Pt component were mixed together to prepare a polyorganosiloxane composition.

[Examples 2 to 4, Comparative examples 1 to 3]

The straight-chain polydimethylsiloxane containing vinyl groups at both ends A1 obtained in the synthesis example 1, any one of the vinyl-group containing resinoid polysiloxanes B1 to B3 obtained in the synthesis examples 2 to 4, any one of the resinoid polymethylhydrogensiloxanes C1 to C5 obtained in the synthesis examples 5 to 9, and the (D) platinum complex solution having a tetramethyltetravinylcyclotetrasiloxane as a ligand, were mixed together at respective proportions listed in Table 1 in a manner similar to the example 1, to thereby prepare polyorganosiloxane compositions.

Note that among the resinoid polymethylhydrogensiloxanes C1 to C5, each of C1 and C2 is the resinoid polymethylhydrogensiloxane in a range of the component (C) of the present invention, and each of C3 to C5 is the resinoid polymethylhydrogensiloxane which is out of the range of the component (C) of the present invention. In Table 1, the component of each of the resinoid polymethylhydrogensiloxanes C3 to C5 is indicated as (Cf).

Regarding the polyorganosiloxane compositions obtained in the examples 1 to 4 and the comparative examples 1 to 3 as described above, the content of P, and the contents of Na, K, and Cs as alkali metals were respectively measured. Table 1 shows the total amount (mass ppm) of P and the alkali metals.

[Evaluation of moldability]

Next, regarding the polyorganosiloxane compositions obtained in the examples 1 to 4 and the comparative examples 1 to 3, the moldability was evaluated. Molding of injecting each of the compositions into a metal mold (20 mm × 170 mm, depth of 2 mm) and curing it was repeated at a molding temperature of 140°C by using EC100N Injection Molding Machine manufactured by TOSHIBA CORPORATION. Note that the curing time was set to 30 seconds.

Further, the haze of the molded product was measured every 50 shots by using micro-TRI-gloss manufactured by BYK Gardner, the rate of change in haze from the first shot was calculated from the following formula, and the number of shots at which the rate of change exceeded 50% was determined.

$$\text{Rate of change in haze (\%)} = \{(\text{haze of molded product of every 50 shots} -$$

$$\text{haze of molded product at first shot})/(\text{haze of molded product at first shot})\} \times 100$$

Results are shown in Table 1. Note that the number of shots at which the rate of change in haze was 50% in the examples 1 to 4 means that the rate of change in haze did not become 50% even at 1100th shot. In the comparative examples, the number of shots at which the rate of change in haze exceeded 50% and had a numeric value in parentheses was indicated.

The change in haze of the molded product is an index indicating the degree of contamination of the metal mold due to the repetition of injection molding. It is indicated that as the number of shots at which the rate of change in haze becomes 50% is larger, the metal mold is less contaminated by the repeatedly-performed injection molding, namely, it is easier for the cured product to be released from the metal mold and the formation of coating film of silicone on a surface of the metal mold is suppressed more.

[Table 1]

| | | | Example 1 | Example 2 | Example 3 | Example 4 | Comparative example 1 | Comparative example 2 | Comparative example 3 |
|---|---|---|---|---|---|---|---|---|---|
| Composition (parts by mass) | (A) | Straight-chain polydimethylsiloxane containing vinyl groups at both ends A1 (viscosity 80 Pa·s) | 60 | 60 | 60 | 60 | 60 | 60 | 60 |
| | (B) | Vinyl group-containing resinoid polysiloxane B1 | 40 | | 40 | | | | 40 |
| | | Vinyl group-containing resinoid polysiloxane B2 | | 40 | | | | 40 | |
| | | Vinyl group-containing resinoid polysiloxane B3 | | | | 40 | 40 | | |
| | (C) | Si-H-containing resinoid polysiloxane C1 Mass decrease rate 1.8%, OE/Si-H=0.13 | 8.9 | 8.9 | | 8.9 | | | |
| | | Si-H-containing resinoid polysiloxane C2 Mass decrease rate 0.1%, OE/Si-H=0.08 | | | 9.1 | | | | |
| | (Cf) | Si-H-containing resinoid polysiloxane C3 Mass decrease rate 40%, OE/Si-H=0.03 | | | | | 8.2 | | |
| | | Si-H-containing resinoid polysiloxane C4 Mass decrease rate 12%, OE/Si-H=0.03 | | | | | | 8.4 | |
| | | Si-H-containing resinoid polysiloxane C5 Mass decrease rate 0.2%, OE/Si-H=0.22 | | | | | | | 8.9 |
| | (D) | Pt-based catalyst (as Pt component) (ppm) | 3 | 3 | 3 | 3 | 3 | 3 | 3 |
| Si-H/Vi molar ratio (Si-H in component (C)/Vi in components (A), (B)) | | | 2.0 | 2.0 | 2.0 | 2.0 | 2.0 | 2.0 | 2.0 |
| Total of contents of phosphorus and alkali metal (ppm) | | | <10 | <10 | <10 | 19 | 19 | <10 | <10 |
| Moldability | Number of shots at which rate of change in haze becomes 50% | | >1100 | >1100 | >1100 | >1100 | 200 (62%) | 950 (85%) | 150 (117%) |

The following is found from Table 1. Specifically, the polyorganosiloxane compositions in the examples 1 to 4 made by compounding the respective components of (A) to (D) at predetermined compositions defined in the present invention are excellent in mold release property of the cured products with respect to the metal mold, and do not contaminate the metal mold almost at all even when injection molding is repeatedly performed. Further, their molded products have less change in haze and keep initial transparency.

On the contrary, each of the polyorganosiloxane compositions in the comparative examples 1 and 2 uses the methylhydrogenpolysiloxane whose mass decrease rate when heated at 150°C for 30 minutes exceeds 2.0%, being the resinoid polymethylhydrogensiloxane (Cf) which is out of the range of the component (C) of the present invention, so that its mold release property and non-contamination property with respect to the metal mold are poor, and the change in haze of the molded product caused by the repeated shots is large. Further, the polyorganosiloxane composition in the comparative example 3 uses the methylhydrogenpolysiloxane whose mass decrease rate when heated at 150°C for 30 minutes is 2.0% or less, but whose alkoxy groups/Si-H is 0.15 or more, being the resinoid polymethylhydrogensiloxane (Cf) which is out of the range of the component (C) of the present invention, so that its mold release property and non-contamination property with respect to the metal mold are poor, and the change in haze of the molded product caused by the repeated shots is large.

INDUSTRIAL APPLICABILITY

According to the polyorganosiloxane composition for molding of the present invention, it is possible to obtain a cured product having good moldability, which is easily released from a metal mold and thus which suppresses contamination of the metal mold. Further, the cured product does not contaminate the metal mold almost at all, which can increase productivity of molded products. Therefore, the molded product obtained from the polyorganosiloxane composition is suitable, for example, for an optical member such as a sealing material of a light-emitting element in a light emitting device such as an LED device, and a functional lens. In particular, the molded product can be suitably used as a lens and cover of an outdoor light source and automobile light source.

**Claims**

1. A polyorganosiloxane composition for molding, comprising:

   (A) a straight-chain polyorganosiloxane having two or more alkenyl groups bonded to silicon atoms on average in one molecule, and having a viscosity at 25°C of 10,000 to 1,000,000 mPa·s;
   (B) 30 to 80 mass% of a polyorganosiloxane having a resin structure to a total of the component (A) and the component (B), the polyorganosiloxane containing tetrafunctional siloxane units represented by a formula: $SiO_{4/2}$ and having 1.5 or more alkenyl groups bonded to silicon atoms on average in one molecule;
   (C) a polyorganohydrogensiloxane having three or more hydrogen atoms bonded to silicon atoms on average in one molecule, and having monofunctional siloxane units represented by a formula: $R^4_3SiO_{1/2}$, where $R^4$s independently represent a methyl group or a hydrogen atom, and tetrafunctional siloxane units represented by a formula: $SiO_{4/2}$, the polyorganohydrogensiloxane having zero or more alkoxy groups bonded to silicon atoms, having a molar ratio of the alkoxy groups to the hydrogen atoms bonded to the silicon atoms (a number of moles of alkoxy groups/a number of moles of hydrogen atoms bonded to silicon atoms) of less than 0.15, and having a mass decrease rate when heated at 150°C for 30 minutes of 2.0% or less, wherein an amount of the hydrogen atoms bonded to the silicon atoms in the component (C) becomes 1.0 to 3.0 mol to a total 1 mol of the alkenyl groups in the component (A) and the alkenyl groups in the component (B); and
   (D) a catalytic amount of a hydrosilylation reaction catalyst.

2. The polyorganosiloxane composition for molding according to claim 1, wherein
   the component (C) includes a polyorganohydrogensiloxane having a molar ratio of the alkoxy groups to the hydrogen atoms bonded to the silicon atoms (a number of moles of alkoxy groups/a number of moles of hydrogen atoms bonded to silicon atoms) of less than 0.10.

3. The polyorganosiloxane composition for molding according to claim 1 or 2, wherein
   the component (C) includes a polyorganohydrogensiloxane having a mass decrease rate when heated at 150°C for 30 minutes of 0.5% or less.

4. The polyorganosiloxane composition for molding according to any one of claims 1 to 3, wherein
   the polyorganosiloxane composition for molding does not contain an inorganic filler, and a cured product thereof having a thickness of 6 mm has a transmittance of light with a wavelength of 400 nm of 85% or more.

5. An optical member made by curing the polyorganosiloxane composition for molding according to any one of claims 1 to 4.

6. The optical member according to claim 5, wherein
   the optical member is a light source lens or a light source cover.

7. The optical member according to claim 6, wherein
   the light source is at least one kind selected from indoor or outdoor lighting, a reading light and accent lighting of public transport, and an LED street light.

8. The optical member according to claim 5, wherein
   the optical member is at least one kind selected from a primary or secondary LED lens, a thick optical lens, an LED reflector, an automobile LED matrix lighting lens, an augmented reality optical member, an LED chip silicone optical head, a work light lens and reflector, an illumination optical member for smartphone or tablet, an LED display for computer or television, and a light guide.

9. A molding method, comprising:

   performing molding by a method selected from injection molding, compression molding, transfer molding, potting, and dispensing, by using the polyorganosiloxane composition for molding according to any one of claims 1 to 4.

**INTERNATIONAL SEARCH REPORT**

| International application No. |
|---|
| PCT/JP2019/023071 |

A. CLASSIFICATION OF SUBJECT MATTER
Int.Cl. C08L83/07(2006.01)i, C08K3/01(2018.01)i, C08L83/05(2006.01)i,
    G02B1/04(2006.01)i, H01L33/58(2010.01)i

According to International Patent Classification (IPC) or to both national classification and IPC

B. FIELDS SEARCHED

Minimum documentation searched (classification system followed by classification symbols)
Int.Cl. C08L83/07, C08K3/01, C08L83/05, G02B1/04, H01L33/58

Documentation searched other than minimum documentation to the extent that such documents are included in the fields searched
    Published examined utility model applications of Japan          1922-1996
    Published unexamined utility model applications of Japan        1971-2019
    Registered utility model specifications of Japan                1996-2019
    Published registered utility model applications of Japan        1994-2019

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2016/098884 A1 (MOMENTIVE PERFORMANCE MATERIALS JAPAN LLC) 23 June 2016, claims, paragraphs [0060]-[0111], table 1 & US 2017/0283614 A1 claims, paragraphs [0085]-[0151], table 1 & US 2017/0283613 A1 & EP 3235873 A1 & EP 3235872 A1 & KR 10-2017-0098819 A & CN 107429062 A & CN 107001803 A & KR 10-2017-0098818 A | 1-9 |

☒ Further documents are listed in the continuation of Box C.      ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 15 August 2019 (15.08.2019) | 27 August 2019 (27.08.2019) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

International application No.

PCT/JP2019/023071

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2014-40522 A (SHIN-ETSU CHEMICAL CO., LTD.) 06 March 2014, entire text (Family: none) | 1-9 |
| A | JP 2016-155967 A (SHIN-ETSU CHEMICAL CO., LTD.) 01 September 2016, entire text & US 2016/0251482 A1 whole document & EP 3061783 A1 & EP 3061783 A1 & KR 10-2016-0104559 A & TW 201702346 A & CN 105924974 A | 1-9 |
| A | WO 2014/104080 A1 (MOMENTIVE PERFORMANCE MATERIALS JAPAN LLC) 03 July 2014, entire text & US 2015/0337189 A1 whole document & EP 2940077 A1 & CN 104870568 A & KR 10-2015-0099581 A & TW 201431963 A | 1-9 |
| A | WO 2018/055896 A1 (SHIN-ETSU CHEMICAL CO., LTD.) 29 March 2018, entire text & CN 109715731 A & KR 10-2019-0055074 A & TW 201817819 A | 1-9 |

Form PCT/ISA/210 (continuation of second sheet) (January 2015)

**EP 3 808 816 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI11140319 A
- JP 4697405 B
- JP 2009185257 A